(19) Europäisches Patentamt
European Patent Office
Office européen des brevets

(11) **EP 4 636 816 A1**

(12) **EUROPEAN PATENT APPLICATION**
published in accordance with Art. 153(4) EPC

(43) Date of publication:
**22.10.2025 Bulletin 2025/43**

(51) International Patent Classification (IPC):
**H01L 21/677** (2006.01)    **B25J 15/08** (2006.01)
**H01L 21/68** (2006.01)

(21) Application number: 23903525.6

(22) Date of filing: 13.12.2023

(52) Cooperative Patent Classification (CPC):
**B25J 15/08; H01L 21/677; H01L 21/68**

(86) International application number:
**PCT/JP2023/044560**

(87) International publication number:
**WO 2024/128241 (20.06.2024 Gazette 2024/25)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **16.12.2022 JP 2022201128**

(71) Applicant: Ebara Corporation
**Ohta-ku, Tokyo 144-8510 (JP)**

(72) Inventors:
• **YAMANOBE, Hokuto**
  **Tokyo 144-8510 (JP)**
• **ISHIKAWA, Sho**
  **Tokyo 144-8510 (JP)**
• **HONG, Kuo-wei**
  **Tokyo 144-8510 (JP)**
• **YAZAWA, Akihiro**
  **Tokyo 144-8510 (JP)**

(74) Representative: **Carstens, Dirk Wilhelm**
**Wagner & Geyer Partnerschaft mbB**
**Patent- und Rechtsanwälte**
**Gewürzmühlstraße 5**
**80538 München (DE)**

(54) **TRANSFER MACHINE AND SUBSTRATE PROCESSING DEVICE**

(57)    A transfer machine 80 has an arm 810; a holding part 830 that is provided on the arm 810 and that is configured to hold a substrate W; a turning part 100 that turns the arm 810 about a turning axis A; and a control part 50 that adjusts a position in an in-plane direction of the substrate W by turning the arm 810 by the turning part 100 based on the position in the in-plane direction of the substrate W, which is held by the holding part 830, measured by measurement part 110.

[FIG. 5]

**Description**

TECHNICAL FIELD

The present invention relates to a transfer machine that conveys a substrate, and a substrate processing apparatus that polishes a circumferential part of the substrate conveyed and carried out by the transfer machine.

BACKGROUND ART

Conventionally, a substrate processing apparatus including a bevel polishing device for polishing a bevel of a substrate such as a wafer has been known. While variation may occur when polishing the bevel of the substrate with the bevel polishing device, attempts have been made to suppress such variation. JP 2006-192522 A proposes that position adjustment of a polishing head when performing bevel polishing is performed using a jig.

SUMMARY OF INVENTION

PROBLEM TO BE SOLVED BY INVENTION

The present invention provides an aspect in which a positional deviation of a substrate is prevented by a simple mechanism as compared with a conventional aspect, and variation in polishing a bevel of the substrate is suppressed.

MEANS FOR SOLVING PROBLEM

[Concept 1]

A transfer machine may comprise:

an arm;
a holding part that is provided on the arm and that is configured to hold a substrate;
a turning part that turns the arm about a turning axis; and
a control part that adjusts a position in an in-plane direction of the substrate by turning the arm by the turning part based on the position in the in-plane direction of the substrate measured by measurement part.

[Concept 2]

In the transfer machine according to concept 1,
the turning axis may extend in a direction orthogonal to a substrate carry-in direction.

[Concept 3]

In the transfer machine according to concept 2,
the turning axis may be provided on a carry-in port side than the holding part and may extend in the in-plane direction of the substrate before being turned by the turning part.

[Concept 4]

The transfer machine according to any one of concepts 1 to 3 may further comprise a support member that is provided below the arm and that supports the substrate,
wherein the turning part may be provided below a support part and below a conveyance path of a substrate conveyance mechanism.

[Concept 5]

A substrate processing apparatus may comprise:

a transfer machine having an arm, a holding part that is provided on the arm and that is configured to hold a substrate, and a turning part that turns the arm about a turning axis;
a measurement part that measures a position in an in-plane direction of the substrate held by the holding part; and

a control part that adjusts the position of the substrate by turning the arm by the turning part based on the position in the in-plane direction of the substrate measured by the measurement part.

[Concept 6]

In the substrate processing apparatus according to concept 5,
the measurement part may have a first measurement part and a second measurement part provided at a position that is point symmetric to the first measurement part with respect to a center of the substrate.

[Concept 7]

In the substrate processing apparatus according to concept 6,
a diameter of the substrate may be calculated from measurement results by the first measurement part and the second measurement part, thereby a deviation amount of a size from an ideal diameter of the substrate may be calculated, and the position of the substrate may be adjusted by turning of the turning part based on the calculation result using the deviation amount of the size.

[Concept 8]

In the substrate processing apparatus according to any one of concepts 5 to 7,
an angle deviation amount of a tip position of the substrate about the turning axis with respect to a tip position at an ideal position of the substrate may be calculated, and the position of the substrate may be adjusted by turning of the turning part based on the calculation result using the angle deviation amount.

[Concept 9]

In the substrate processing apparatus according to any one of concepts 6 to 8,
the first measurement part and the second measurement part may be disposed at positions deviated by a predetermined angle $\theta$ with respect to a carry-in and carry-out direction of the substrate.

[Concept 10]

In the substrate processing apparatus according to any one of concepts 6 to 9,

a jig substrate for setting zero points of the first measurement part and the second measurement part may be available, and
the jig substrate may have an adsorbed part adsorbed by a substrate adsorbing/holding part, and an adjustment part movable in an in-plane direction with respect to the adsorbed part.

[Concept 11]

In the substrate processing apparatus according to any one of concepts 5 to 10,
the measurement part may have a line sensor.

[Concept 12]

The substrate processing apparatus according to any one of concepts 5 to 11 may comprise a substrate adsorbing/holding part absorbs and holds the substrate,
an elastic member may be provided on a placement surface of the substrate adsorbing/holding part.

EFFECT OF THE PRESENT INVENTION

As one aspect of the present invention, in a case where a position of a substrate is adjusted by turning arms by a turning part about a turning axis based on the position of the substrate measured by a measurement part, it is possible to deliver the substrate after adjusting the position from a base transfer machine to a substrate adsorbing/holding part only by simple control of turning the turning part.

BRIEF DESCRIPTION OF FIGURES

[Fig. 1] Fig. 1 is a plan view of a transfer machine that can be used in an embodiment of the present invention.

[Fig. 2] Fig. 2(a) is a side view illustrating an aspect in which a substrate is conveyed to a substrate adsorbing/holding part by a transfer machine that can be used in the embodiment of the present invention, Fig. 2(b) is a side view illustrating a state advanced from the state illustrated in Fig. 2(a) and a state in which the substrate is delivered to the substrate adsorbing/holding part, and

Fig. 2(c) is a side view illustrating a state advanced from the state illustrated in Fig. 2(b) and a state in which the transfer machine is separated.

[Fig. 3] Fig. 3 is a plan view of the transfer machine that can be used in the embodiment of the present invention, and is a view for describing an aspect of measuring a deviation (including a manufacturing error and a positional deviation) of the substrate.

[Fig. 4] Fig. 4 is a plan view for describing the aspect of measuring the deviation (including a manufacturing error and a positional deviation) of the substrate in more detail.

[Fig. 5] Fig. 5 is a side view for describing an aspect in which a position of the substrate is adjusted by turning of a turning part.

[Fig. 6] Fig. 6 is a side view illustrating a measurement part including a line sensor that can be used in the embodiment of the present invention.

[Fig. 7] Fig. 7(a) is a side view for describing an aspect in which the turning part is provided below a conveyance path of a substrate conveyance mechanism such as a robot hand, and Fig. 7(b) is a side view illustrating an aspect in which the substrate conveyance mechanism such as a robot hand is separated from arms or the like.

[Fig. 8] Fig. 8 is a perspective view illustrating the robot hand which is an example of the substrate conveyance mechanism.

[Fig. 9] Fig. 9 is a view for describing an aspect in which a zero point of the measurement part is set using a jig substrate, Fig. 9(a) is a side view illustrating an aspect in which a position of the jig substrate is deviated, and Fig. 9(b) is a side view illustrating an aspect in which the position of the jig substrate is not deviated.

[Fig. 10] Fig. 10 is a plan view illustrating a slide mechanism provided in an adjustment part of the jig substrate.

[Fig. 11] Fig. 11 is a side view illustrating an aspect in which an elastic member is provided on a placement surface of the substrate adsorbing/holding part.

[Fig. 12] Fig. 12 is a schematic view illustrating a configuration of a bevel polishing system.

[Fig. 13] Fig. 13 is a plan view illustrating a bevel polishing device that can be used in the embodiment of the present invention.

EMBODIMENT FOR IMPLEMENTING INVENTION

EMBODIMENT

<<Configuration>>

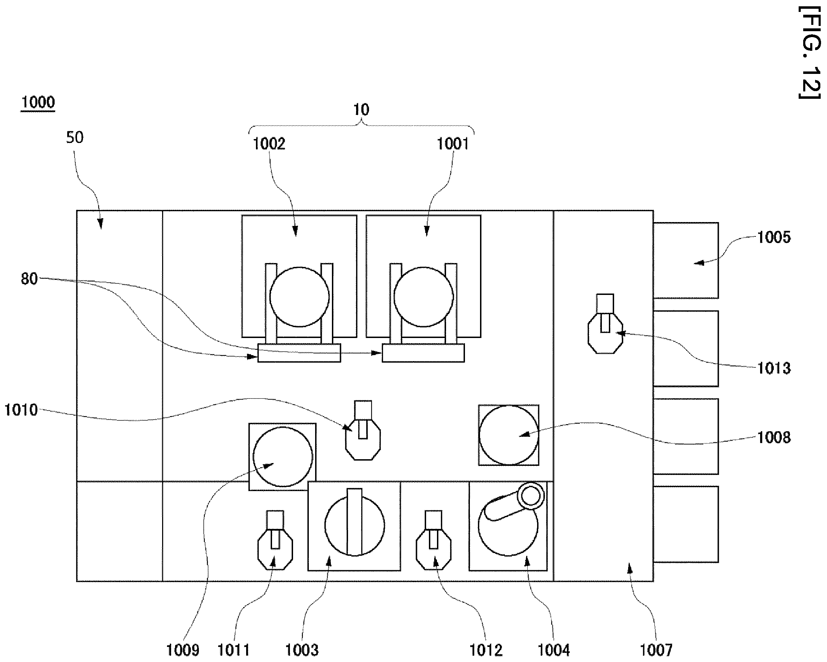

Fig. 12 is a plan view illustrating the bevel polishing system including the bevel polishing device according to the embodiment of the present invention. Note that the bevel polishing system is an example of a substrate processing apparatus. As illustrated in Fig. 12, a bevel polishing system 1000 has a FOUP 1005 which is a load port, an EFEM 1007, a plurality of bevel polishing devices 10 (hereinafter, may be referred to as a first polishing part 1001 and a second polishing part 1002), a cleaning unit 1003, a dryer 1004, a plurality of substrate temporary placing stands 1008 and 1009, a plurality of conveyors 1010 to 1013, and a control part 50. Note that the control part 50 may be provided at a remote location to remotely control the bevel polishing system 1000.

In the configuration of the bevel polishing system 1000 as illustrated in Fig. 12, a substrate W including a wafer or the like is processed by the following procedure. That is, the substrate W is placed on the substrate temporary placing stand 1008 from the FOUP 1005 via the conveyor 1013 in the EFEM 1007. Next, the substrate W on the substrate temporary placing stand 1008 is conveyed to either the first polishing part 1001 or the second polishing part 1002 by the conveyor 1010 and polished. The polished substrate W is conveyed to the substrate temporary placing stand 1009 by the conveyor 1010. Thereafter, the substrate W on the substrate temporary placing stand 1009 is conveyed to the cleaning unit 1003 by the conveyor 1011 and cleaned. Next, the cleaned substrate W is conveyed to the dryer 1004 by the conveyor 1012, dried in the dryer 1004, and then carried out to the FOUP 1005 by the conveyor 1013.

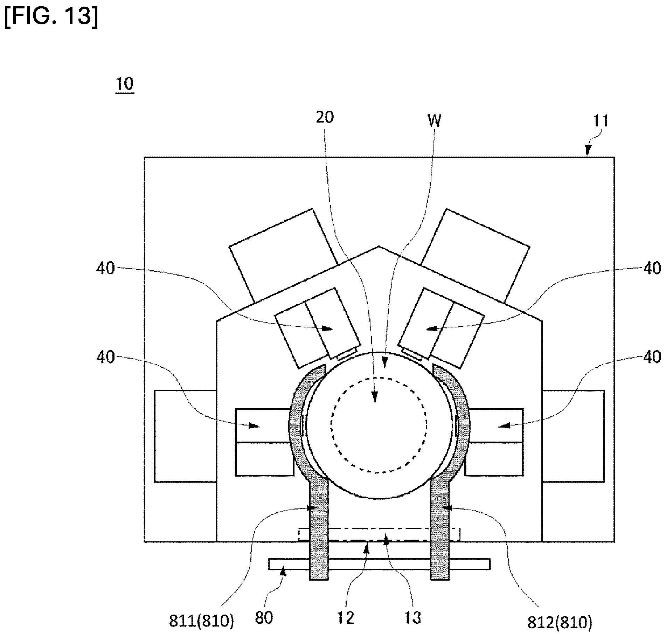

Fig. 13 is a plan view illustrating the bevel polishing device 10 according to the present embodiment. As illustrated in Fig. 13, the bevel polishing device 10 according to the present embodiment is a device for polishing a circumferential part (edge and bevel) of the substrate W, and has a housing 11, a substrate adsorbing/holding part (substrate holding part) 20 including a substrate stage or the like for holding the substrate W in the housing 11, polishing units 40 including a bevel polishing unit or the like for polishing the peripheral edge of the substrate W held by the substrate adsorbing/holding part 20, and a transfer machine 80 for placing the substrate W carried into the housing 11 on the substrate adsorbing/holding part 20 and removing the substrate W held by the substrate adsorbing/holding part 20 from the substrate adsorbing/holding part 20.

Among them, the polishing units 40 polish the circumferential part of the substrate W held by the substrate adsorbing/holding part 20. In the illustrated example, four polishing units 40 are provided in the housing 11, but the present invention is not limited thereto, and two, three, or five or more polishing units 40 may be provided. The polishing unit 40 may have a polishing tape (not illustrated), a polishing pad (not illustrated) which is a pressing part for pressing the polishing tape against the substrate W, and a pressing force adjustment part (not illustrated) including an air cylinder or the like that adjusts a pressing force of the polishing tape against the substrate W using gas.

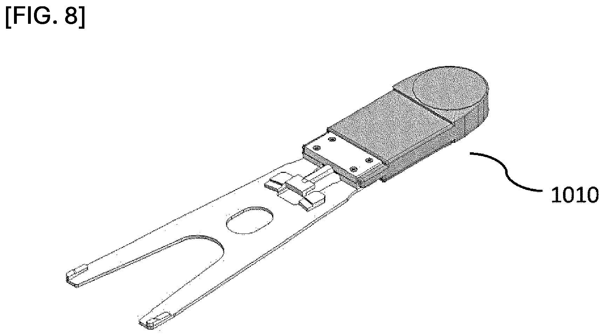

As illustrated in Fig. 13, the housing 11 has an opening 12 on a side surface thereof. The opening 12 is opened and closed by a shutter 13 driven by a cylinder (not illustrated). The substrate W is carried into and out of the housing 11 by a substrate conveyance mechanism 1010 (see also Fig. 8) including a robot hand or the like. For example, as illustrated in Fig. 12, when the substrate W is carried into the first polishing part 1001, the substrate W on the substrate temporary placing stand 1008 is placed on the robot hand which is the substrate conveyance mechanism 1010. Next, as illustrated in Fig. 13, the opening 12 of the housing 11 is opened by the shutter 13, the substrate W is transferred from the robot hand serving as the substrate conveyance mechanism 1010 to arms 810 of the transfer machine 80, and then, the substrate W is placed on the substrate adsorbing/holding part 20 from the transfer machine 80, and the opening 12 of the housing 11 is closed after the substrate conveyance mechanism 1010 is retracted. Further, for example, when the substrate W is carried out after the first polishing part 1001 finishes polishing the bevel part of the substrate W, the substrate W is placed on the arms 810 of the transfer machine 80, and the opening 12 of the housing 11 is opened by the shutter 13. Next, the substrate W on the arms 810 of the transfer machine 80 is carried out of the housing 11 by the substrate conveyance mechanism 1010 after being placed on the substrate conveyance mechanism 1010, is placed on the substrate temporary placing stand 1009, and the opening 12 of the housing 11 is closed by the shutter 13. When the opening 12 of the housing 11 is closed by the shutter 13, the inside of the housing 11 is blocked from the outside. As a result, cleanliness and confidentiality in the housing 11 are maintained during polishing, and contamination of the substrate W from the outside of the housing 11 and contamination of the outside of the housing 11 due to scattering of polishing liquid, particles, and the like from the inside of the housing 11 are prevented.

Next, a structure of the transfer machine 80 according to the present embodiment will be described. The transfer machine 80 is a device for conveying the substrate W to the substrate adsorbing/holding part 20 that holds a back surface of the substrate W. The substrate adsorbing/holding part 20 is, for example, a stage that adsorbs and holds the back surface of the substrate W.

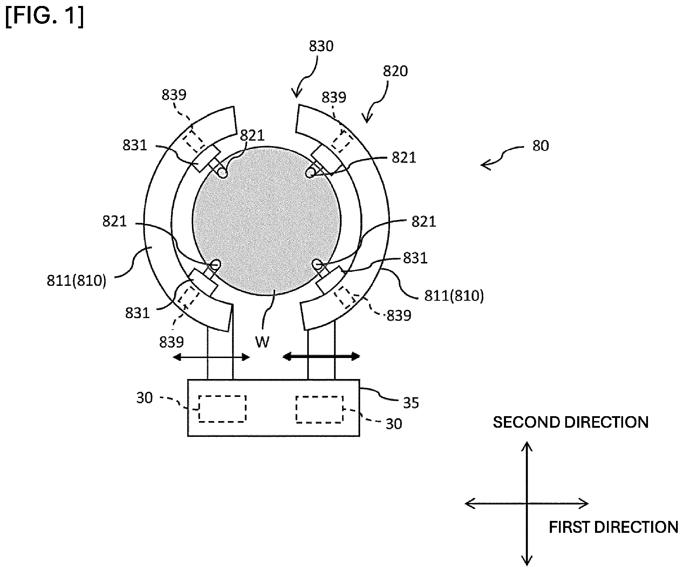

As illustrated in Fig. 1, the transfer machine 80 may have a pair of arms 810, a support part 820 having support members 821 that support the back surface of the substrate W, and a holding part 830 having holding members 831 made of a chuck top or the like that holds the side surface of the substrate W. Two support members 821 may be provided on one arm 810, two support members 821 may be provided on the other arm 810, and a total of four support members 821 may be provided. The support members 821 may be provided below the arms 810. Two holding members 831 for holding the substrate W from the side may be provided in one arm 810, two holding members 831 for holding the substrate W from the side may be provided in the other arm 810, and a total of four holding members 831 may be provided. The transfer machine 80 may have drive parts 30 that move the pair of arms 810 so as to approach or separate symmetrically in an opening/closing direction. The driving by the drive part 30 may be performed by using a ball screw and an LM guide. Further, as disclosed in JP 2017-112291 A, a configuration using an annular belt may be adopted. As the shape of the holding member 831, various shapes such as a rectangular parallelepiped shape, a cubic shape, and a cylindrical shape can be adopted. Fig. 1 illustrates an aspect in which the holding member 831 has a rectangular shape in plan view, but the present invention is not limited thereto, and the holding member 831 may have an arc shape in plan view.

As illustrated in Fig. 1, the other arm 810 may have the same length as the one arm 810. However, the present invention is not limited to such an aspect, and the length of the other arm 810 and the length of the one arm 810 may be different from each other.

At least one of the support members 821 may be movable in an in-plane direction (for example, a first direction) of the substrate W. The movement of the support members 821 in the in-plane direction of the substrate W may be adjusted by driving the first arm 810 and/or the second arm 810 with the drive parts 30 (see Fig. 1), or each of the support members 821 may be movable with respect to the arms 810, and the support members 821 may move in the in-plane direction of the substrate W by changing the positions of the support members 821 with respect to the arms 810. In the present embodiment, the description will be given assuming that the in-plane direction of the substrate W is a horizontal direction and a normal direction of the substrate W is a vertical direction, but the present invention is not necessarily limited thereto, and the in-plane direction of the substrate W may be inclined from the horizontal direction and the normal direction of the substrate W may be inclined from the vertical direction.

When the position adjustment of the support members 821 in the in-plane direction of the substrate W is performed by the movement of the arms 810, one of the first arm 810 and the second arm 810 may be movable, and the other may be fixed. That is, the second arm 810 may be fixed, and the first arm 810 may be movable in the in-plane direction of the substrate W by the drive parts 30, or the first arm 810 may be fixed, and the second arm 810 may be movable in the in-plane direction of the substrate W by the drive parts 30. In an aspect in which the support members 821 are movable with respect to the arms 810, any one or more of the four support members may be movable with respect to the arms 810.

The movement of the holding members 831 in the in-plane direction of the substrate W may be adjusted by driving the first arm 810 and/or the second arm 810 with the drive parts 30, or the holding members 831 may be movable with respect to the arms 810, and the holding members 831 may move in the in-plane direction of the substrate W by changing the positions of the holding members 831 with respect to the arms 810. By adjusting the positions of the holding members 831 in the in-plane direction of the substrate W, the positions of the support members 821 connected to the holding members 831 in the in-plane direction of the substrate W may also be simultaneously adjusted. In an aspect in which the holding members 831 are movable with respect to the arms 810, any one or more of the four holding members may be movable with respect to the arms 810.

The movement of the support members 821 and the holding members 831 with respect to the arms 810 may be performed by drive parts 839 such as an electric motor. The drive parts 839 that move the support members 821 and the holding members 831 may be attached to the arms 810 corresponding to each of the support members 821 and each of the holding members 831, or may be provided in a box 35 which is the base portion of the arms 810. The movement of the support members 821 and the holding members 831 with respect to the arms 810 may be performed individually, or the movement of the support members 821 and the holding members 831 with respect to the arms 810 may be performed in conjunction with each other.

At least one of the support members 821 may be movable along the normal direction of the substrate W. The movement of the support members 821 in the normal direction of the substrate W may be adjusted by driving the first arm 810 and/or the second arm 810 with the drive parts 30, or the support members 821 may be movable with respect to the arms 810, and the support members 821 may move in the normal direction of the substrate W by changing the positions of the support members 821 with respect to the arms 810. In addition, a normal direction position detection part (not illustrated) that can detect the positions of the support members 821 and/or the holding members 831 in the normal direction of the substrate W may be provided.

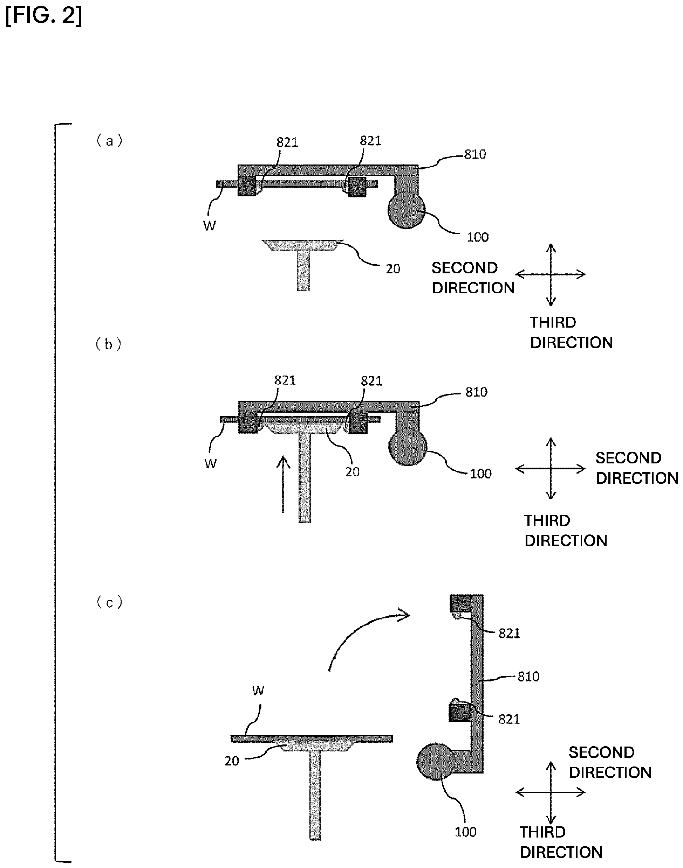

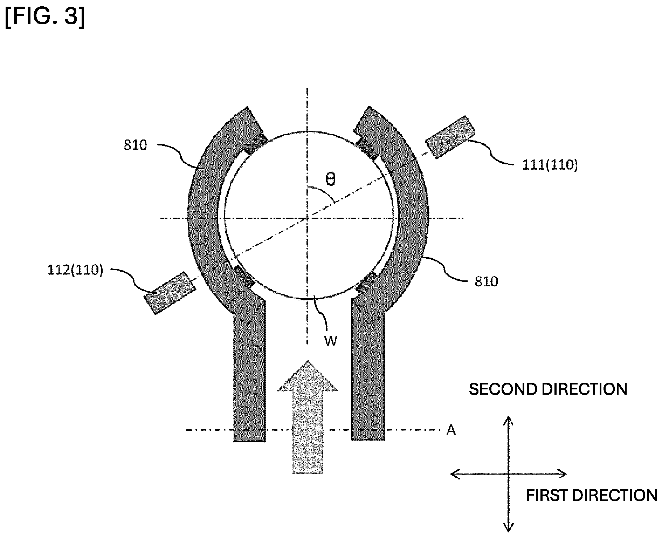

A turning part 100 (see Fig. 2) capable of turning the arms 810 about a turning axis A (see Fig. 3) extending in a direction (first direction, a left-right direction in Fig. 1) orthogonal to a substrate carry-in direction may be provided. In the present embodiment, a substrate carry-in and carry-out direction is referred to as a second direction, and a direction that is the in-plane direction of the substrate W and is orthogonal to the second direction is referred to as a first direction. The normal direction of the substrate W is indicated as a third direction.

As illustrated in Fig. 2, the bevel polishing device has a substrate adsorbing/holding part (substrate holding part) 20 that, for example, adsorbs and holds the back surface of the substrate W conveyed by the transfer machine 80, and the above-described polishing units 40 (see Fig. 13) that polish the bevel of the substrate W held by the substrate adsorbing/holding part 20. The substrate W may be delivered to the substrate adsorbing/holding part 20 by the transfer machine 80 as illustrated in Fig. 2. More specifically, as illustrated in Fig. 2(a), the substrate W whose back surface (lower surface in Fig. 2) is supported by the support members 821 and whose side surface is held by the holding members 831 (see Fig. 1) is carried in by the transfer machine 80. Then, as illustrated in Fig. 2(b), the substrate adsorbing/holding part 20 is raised, the substrate W carried in by the transfer machine 80 is placed on the substrate adsorbing/holding part 20, and the back surface of the substrate W is adsorbed and held. Thereafter, the support and holding of the substrate W by the transfer machine 80 are released, and the substrate W is separated from the transfer machine 80. At this time, as illustrated in Fig. 2(c), the arms 810 are turned by the turning part 100.

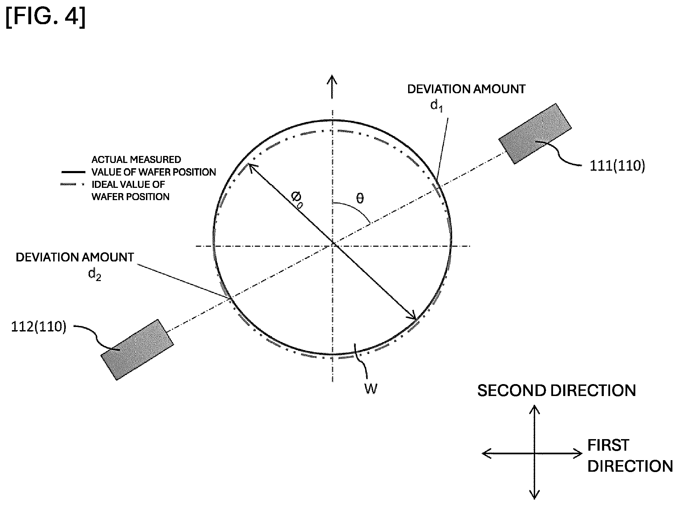

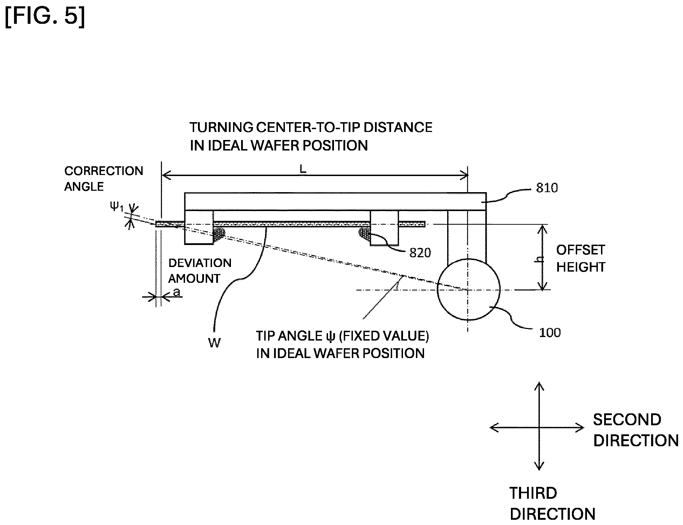

Before the substrate W carried in by the transfer machine 80 is placed on the substrate adsorbing/holding part 20, the control part 50 may adjust the position of the substrate W by turning the arms 810 by the turning part 100 based on the position in the in-plane direction (radial direction) of the substrate W held by the holding part 830 measured by measurement parts 110. In this position adjustment, a deviation amount of the substrate W from a reference position is measured by the measurement parts 110 (see Figs. 3 and 4). Then, a correction angle is calculated by the control part 50 from the deviation amount, and the turning part 100 turns the arms 810 by the correction angle (see Fig. 5). Thereafter, the substrate W is delivered from the transfer machine 80 to the substrate adsorbing/holding part 20 which is an example of the substrate holding part. When the turning part 100 and the control part 50 are adopted, it is advantageous in that the substrate W can be delivered from the transfer machine 80 to the substrate adsorbing/holding part 20 after the position of the substrate W is adjusted only by simple control of turning the arms 810 by the turning part 100. Note that the turning part 100 is often mounted on the conventional transfer machine 80, and in the present aspect, since the delivery position of the substrate W to the substrate adsorbing/holding part 20 can be adjusted by using the turning part 100 as it is, it is very excellent also in that it is not necessary to add a new member in many transfer machines 80.

When the turning axis A of the turning part 100 extends in the direction (first direction) that is the in-plane direction of the substrate W before being turned by the turning part 100 and that is orthogonal to the substrate carry-in direction, the turning part 100 is turned along the turning axis A extending in the in-plane direction of the substrate W, which is advantageous in that the position of the substrate W can be adjusted without providing, for example, a mechanism for sliding the substrate W along the substrate carry-in direction (second direction). Note that the turning part 100 may be provided on a depth direction side (left side in Fig. 2) with respect to the holding part 830, but in this case, it is necessary to enlarge the device configuration on a depth side due to the relationship with other components not illustrated in the present specification. On the other hand, when the turning axis A of the turning part 100 is provided on a carry-in port side (right side in Fig. 2) of the substrate W with respect to the holding part 830, it is excellent in that it is not necessary to enlarge the device configuration.

The measurement parts 110 may measure the position of the substrate W held by the holding part 830 in the in-plane direction (radial direction). As illustrated in Fig. 3, the measurement parts 110 may have a first measurement part 111 and a second measurement part 112 provided at a position that is point symmetric with respect to the center of the substrate W (position that is point symmetric with respect to the center of the substrate W in the in-plane direction of the substrate W) to the first measurement part 111. By adopting such an aspect, a diameter of the substrate W can be calculated, and the deviation from the center of the substrate W can be easily grasped.

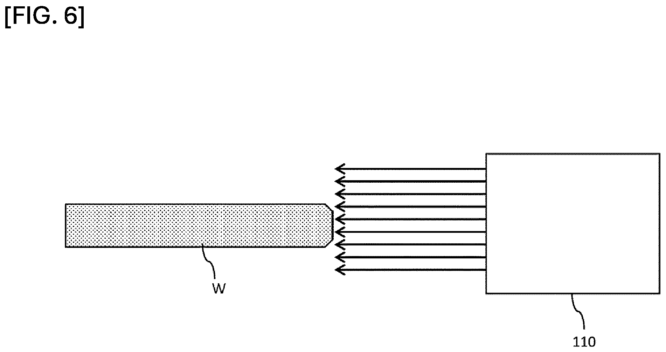

A line sensor may be used as the measurement parts 110 (see Fig. 6). In this case, each of the first measurement part 111 and the second measurement part 112 may include a line sensor. By adopting such a line sensor, it is possible to ignore the deviation of the substrate W in the vertical direction. However, the present invention is not limited to such an aspect, and a CCD camera or the like may be used as the measurement parts 110 instead of the line sensor.

The control part 50 may calculate the diameter of the substrate W from the measurement results by the first measurement part 111 and the second measurement part 112 to calculate a deviation amount in size from an ideal diameter of the substrate W, and then control the turning part 100 to adjust the position of the substrate W (see Fig. 4). By adopting such an aspect, it is advantageous in that the substrate W can be positioned at an appropriate position while taking into account the deviation in size (manufacturing error) for each substrate W.

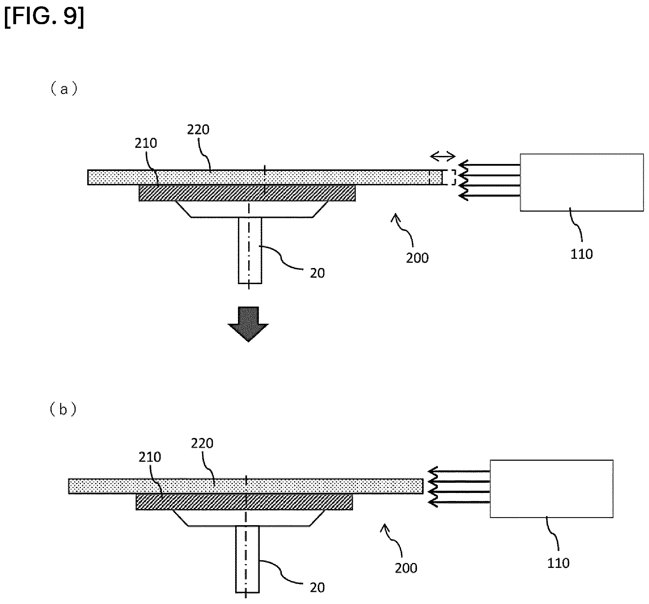

A measurement reference value (zero point determination) of the measurement part 110 may be adjusted by measuring the position of a rotating jig substrate 200 in the in-plane direction (radial direction) in advance (see Figs. 9(a) and 9(b)). The jig substrate 200 may have an ideal diameter of the substrate W. For example, when a substrate W of 300 mm is targeted, a diameter of the jig substrate 200 is 300 mm.

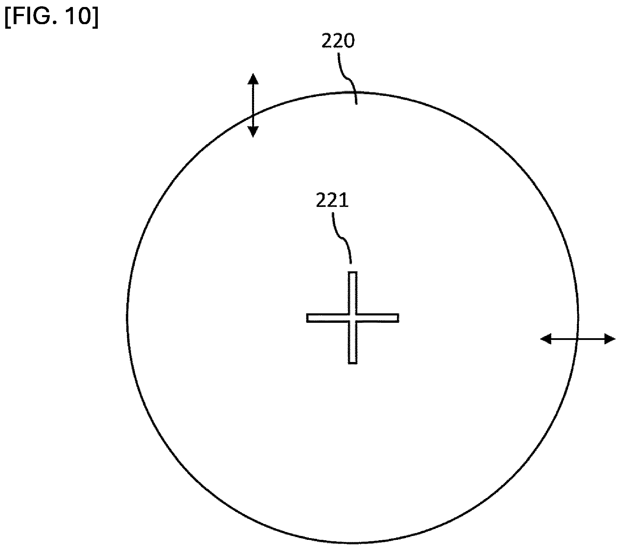

The jig substrate 200 may have an adsorbed part 210 and an adjustment part 220 movable in the in-plane direction with respect to the adsorbed part 210. For example, the adsorbed part 210 and the adjustment part 220 may be connected via a slide mechanism 221 (see Fig. 10). When the position is adjusted, first, the adsorbed part 210 is adsorbed to the substrate adsorbing/holding part 20. Next, the adsorbed part 210 is rotated, and the position of the adjustment part 220 is measured by the measurement parts 110. Next, fixation of the position of the adjustment part 220 with respect to the adsorbed part 210 by a fixing part (not illustrated) is released, and the position of the adjustment part 220 in the in-plane direction is adjusted forward and backward or leftward and rightward by using the slide mechanism 221 (see Fig. 10), and then the position of the adjustment part 220 with respect to the adsorbed part 210 is fixed by the fixing part. Thereafter, the substrate adsorbing/holding part 20 is rotated, and the adjustment is completed when a measured value of the measurement parts 110 does not change or reaches an amount of change in an allowable range, but the adjustment is repeated until the measured value of the measurement parts 110 does not change or reaches the amount of change in the allowable range (see Figs. 9(a) and 9(b)). Then, the measured value in the measurement parts 110 at the time point when the adjustment is completed is set as a zero point. By setting the zero point in this manner, the deviation (including a manufacturing error and a positional deviation) of the substrate W can be measured more accurately.

As illustrated in Figs. 3 and 4, the pair of first measurement part 111 and second measurement part 112 may be disposed at positions deviated by a predetermined angle θ with respect to the carry-in and carry-out direction (second direction) of the substrate W. Since the substrate W is often deviated in the carry-in and carry-out direction, it is preferable to position the first measurement part 111 and the second measurement part 112 with respect to the carry-in and carry-out direction of the substrate W in consideration of only this point. However, when the first measurement part 111 and the second measurement part 112 are provided along the carry-in and carry-out direction of the substrate W, the device configuration becomes larger, and there is a concern about interference with other members such as the substrate conveyance mechanism 1010 including the robot hand or the like that delivers the substrate W to the arms 810. Therefore, it is advantageous that the first measurement part 111 and the second measurement part 112 are disposed at the position deviated by the predetermined angle θ with respect to the carry-in and carry-out direction of the substrate W. The predetermined angle θ is, for example, in a range of 30 to 60 degrees.

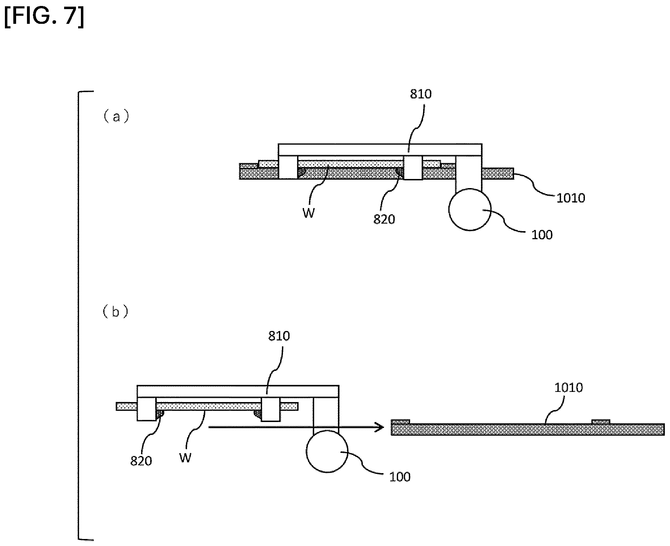

As illustrated in Figs. 7(a) and 7(b), the turning part 100 may be provided below the support part 820 and below a conveyance path of the substrate conveyance mechanism 1010 such as a robot hand. By adopting such an aspect, it is possible to prevent interference between the substrate conveyance mechanism 1010 such as a robot hand and the turning part 100. After delivering the substrate W to the support part 820, the substrate conveyance mechanism 1010 moves to the lower side of the support part 820 and then moves in the carry-out direction (right side in Fig. 7(b)). The side surface of the substrate W whose back surface is supported by the support part 820 in this manner is then held by the holding part 830.

(Calculation of Deviation Amount)

As an example, when a design value of a substrate diameter is denoted by $\Phi_0$, an actual substrate diameter is denoted by $\Phi$, a deviation amount on the first measurement part 111 side is denoted by $d_1$, and a deviation amount on the second measurement part 112 side is denoted by $d_2$,

[Mathematical formula 1]

$$\Phi \simeq \Phi_0 + d_1 + d_2$$

is obtained. In the example illustrated in Fig. 4, $d_1$ is a positive deviation amount, and $d_2$ is a negative deviation amount. Here, $\Phi - \Phi_0$ is a deviation amount of a magnitude.

When the deviation amount with respect to an ideal position in a case of a substrate W having a diameter $\Phi$ [mm] is denoted by $\delta_1$, $d_1 = \delta_1 + (\Phi - \Phi_0)/2$, and thus, $\delta_1 = d_1 + (\Phi_0 - \Phi/2$, and a deviation amount a (see also Fig. 5) to the depth side (upper side in Fig. 4) in the first direction is calculated as a = $\delta_1/\cos\theta$.

(Calculation of Degree of Turning)

In a case where a distance along the second direction from the turning axis A to a tip of the substrate W at the ideal position is denoted by L, when the tip of the substrate W at a position of the second direction component = L + a from the turning axis A is rotated by $\psi_1$, it is adjusted such that the second direction component of the tip of the substrate W = L (see Fig. 5).

Specifically, $\psi_1$ can be calculated by performing the following calculation.

[Mathematical formula 2]

$$L = \sqrt{(L+a)^2 + h^2} \times \cos(\psi + \psi 1)$$

Here, $\psi$ is an angle with respect to the second direction about the turning axis A with respect to the tip of the substrate W at the ideal position, and h is a height of the center of the tip position of the substrate W in the third direction (vertical direction in Fig. 5) from the turning axis A.

In this case, $\psi_1$, which is an angle deviation amount, can be calculated by:

[Mathematical formula 3]

$$\psi + \psi 1 = \arccos\left(\frac{L}{\sqrt{(L+a)^2 + h^2}}\right)$$

[Mathematical formula 4]

$$\psi 1 = \arccos\left(\frac{L}{\sqrt{(L+a)^2 + h^2}}\right) - \arccos\left(\frac{L}{\sqrt{L^2 + h^2}}\right)$$

Therefore, the control part 50 adjusts the position of the substrate W by turning the turning part 100 based on the calculated $\psi_1$.

Note that, as in the example described above, it is very advantageous to perform the position adjustment of the substrate W based on the calculation result using both a deviation in size of the substrate and a deviation in position of the substrate from the viewpoint of accurate positioning, but it is not always necessary to perform both, and the position adjustment of the substrate W may be performed based on the calculation result using only one of the deviation in size of the substrate and the deviation in position of the substrate.

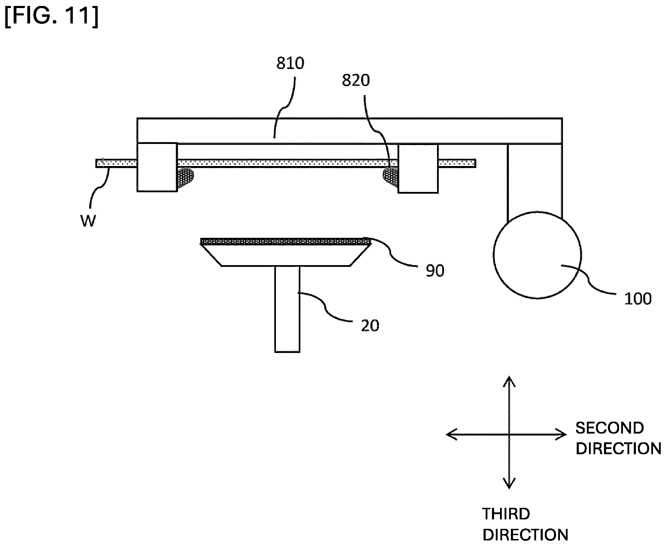

As illustrated in Fig. 11, an elastic member (typically, a silicon film) 90 made of silicon or the like may be provided on the placement surface (upper surface) of the substrate adsorbing/holding part 20. In a case where such an elastic member 90 is provided, the substrate W is placed on the substrate adsorbing/holding part 20 in a state where the substrate W is very slightly inclined (in the above example, in a state where the substrate W is inclined by the correction angle $\psi_1$). Thereafter, the substrate W is adsorbed by the substrate adsorbing/holding part 20, whereby the substrate W is adsorbed and held by the substrate adsorbing/holding part 20 in a state where the position is adjusted. Therefore, providing such an elastic member 90 is advantageous in that the substrate W can be smoothly delivered from the transfer machine 80 to the substrate adsorbing/holding part 20.

The description of the embodiment and the disclosure of the drawings described above are merely examples for explaining the invention described in the claims, and the invention described in the claims is not limited by the description of the embodiment or the disclosure of the drawings described above. In addition, the recitation of the claims at the original application is merely an example, and the recitation of the claims can be appropriately changed based on the description of the specification, the drawings, and the like.

EXPLANATION OF REFERENCE

| 20 | Substrate adsorbing/holding part |
|---|---|
| 50 | Control part |
| 80 | Transfer machine |
| 90 | Elastic member |
| 100 | Turning part |
| 110 | Measurement part |
| 111 | First measurement part |
| 112 | Second measurement part |
| 200 | Jig substrate |
| 210 | Adsorbed part |
| 220 | Adjustment part |
| 810 | Arm |
| 820 | Support part |
| 830 | Holding part |
| W | Substrate |

**Claims**

**1.** A transfer machine comprising:

an arm;
a holding part that is provided on the arm and that is configured to hold a substrate;
a turning part that turns the arm about a turning axis; and
a control part that adjusts a position in an in-plane direction of the substrate by turning the arm by the turning part based on the position in the in-plane direction of the substrate measured by measurement part.

2. The transfer machine according to claim 1,
   wherein the turning axis extends in a direction orthogonal to a substrate carry-in direction.

3. The transfer machine according to claim 2,
   wherein the turning axis is provided on a carry-in port side than the holding part and extends in the in-plane direction of the substrate before being turned by the turning part.

4. The transfer machine according to claim 1 or 2 further comprising a support member that is provided below the arm and that supports the substrate,
   wherein the turning part is provided below a support part and below a conveyance path of a substrate conveyance mechanism.

5. A substrate processing apparatus comprising:

   a transfer machine having an arm, a holding part that is provided on the arm and that is configured to hold a substrate, and a turning part that turns the arm about a turning axis;
   a measurement part that measures a position in an in-plane direction of the substrate held by the holding part; and
   a control part that adjusts the position of the substrate by turning the arm by the turning part based on the position in the in-plane direction of the substrate measured by the measurement part.

6. The substrate processing apparatus according to claim 5,
   wherein the measurement part has a first measurement part and a second measurement part provided at a position that is point symmetric to the first measurement part with respect to a center of the substrate.

7. The substrate processing apparatus according to claim 6,
   wherein a diameter of the substrate is calculated from measurement results by the first measurement part and the second measurement part, thereby a deviation amount of a size from an ideal diameter of the substrate is calculated, and the position of the substrate is adjusted by turning of the turning part based on the calculation result using the deviation amount of the size.

8. The substrate processing apparatus according to claim 5 or 7,
   wherein an angle deviation amount of a tip position of the substrate about the turning axis with respect to a tip position at an ideal position of the substrate is calculated, and the position of the substrate is adjusted by turning of the turning part based on the calculation result using the angle deviation amount.

9. The substrate processing apparatus according to claim 6 or 7,
   wherein the first measurement part and the second measurement part are disposed at positions deviated by a predetermined angle $\theta$ with respect to a carry-in and carry-out direction of the substrate.

10. The substrate processing apparatus according to claim 6 or 7,

    wherein a jig substrate for setting zero points of the first measurement part and the second measurement part is available, and
    wherein the jig substrate has an adsorbed part adsorbed by a substrate adsorbing/holding part, and an adjustment part movable in an in-plane direction with respect to the adsorbed part.

11. The substrate processing apparatus according to claim 5 or 6,
    wherein the measurement part has a line sensor.

12. The substrate processing apparatus according to claim 5 or 6 comprising a substrate adsorbing/holding part absorbs and holds the substrate,
    wherein an elastic member is provided on a placement surface of the substrate adsorbing/holding part.

[FIG. 1]

[FIG. 2]

(a)

821   821   810

W   100

20   SECOND
DIRECTION

THIRD
DIRECTION

(b)

821   821   810

W   100

20

SECOND
DIRECTION

THIRD
DIRECTION

(c)

821

810

W   821

20   SECOND
DIRECTION

100   THIRD
DIRECTION

[FIG. 3]

[FIG. 4]

ACTUAL MEASURED
—— VALUE OF WAFER POSITION
▬ · IDEAL VALUE OF
WAFER POSITION

DEVIATION AMOUNT
$d_1$

111(110)

DEVIATION AMOUNT
$d_2$

112(110)

W

SECOND DIRECTION

FIRST
DIRECTION

[FIG. 5]

TURNING CENTER-TO-TIP DISTANCE
IN IDEAL WAFER POSITION

CORRECTION ANGLE

$\Psi_1$

DEVIATION AMOUNT

a

L

810

820

OFFSET HEIGHT

h

100

W

TIP ANGLE $\psi$ (FIXED VALUE)
IN IDEAL WAFER POSITION

SECOND DIRECTION

THIRD DIRECTION

[FIG. 6]

[FIG. 7]

(a)

810

W
820
1010
100

(b)

810

820    W
1010
100

[FIG. 8]

1010

[FIG. 9]

(a)

(b)

[FIG. 10]

220

221

[FIG. 11]

SECOND DIRECTION

THIRD DIRECTION

[FIG. 12]

EP 4 636 816 A1

[FIG. 13]

23

## INTERNATIONAL SEARCH REPORT

| | International application No. |
|---|---|
| | **PCT/JP2023/044560** |

| A. | CLASSIFICATION OF SUBJECT MATTER |
|---|---|

*H01L 21/677*(2006.01)i; *B25J 15/08*(2006.01)i; *H01L 21/68*(2006.01)i
FI:  H01L21/68 A; B25J15/08 U; H01L21/68 F

According to International Patent Classification (IPC) or to both national classification and IPC

| B. | FIELDS SEARCHED |
|---|---|

Minimum documentation searched (classification system followed by classification symbols)

H01L21/677; B25J15/08; H01L21/68

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2015-156437 A (TOKYO ELECTRON LIMITED) 27 August 2015 (2015-08-27) | 1-2, 5-6, 9, 11 |
| | paragraphs [0022]-[0024], [0028], [0031]-[0033], [0042], [0048]-[0056], fig. 1-6, 9-11 | |
| Y | | 4 |
| A | | 3, 7-8, 10, 12 |
| Y | JP 2020-104240 A (EBARA CORPORATION) 09 July 2020 (2020-07-09) | 4 |
| | paragraph [0025], fig. 1 | |
| A | | 1-3, 5-12 |
| X | JP 2022-123417 A (SUMITOMO HEAVY INDUSTRIES, LTD.) 24 August 2022 (2022-08-24) | 1-2, 5, 8, 11 |
| | paragraphs [0010]-[0012], [0020]-[0023], [0029]-[0033], fig. 1, 3-5 | |
| Y | | 12 |
| A | | 3-4, 6-7, 9-10 |

☑ Further documents are listed in the continuation of Box C. ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **22 February 2024** | **05 March 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

| International application No. |
|---|
| **PCT/JP2023/044560** |

**C.     DOCUMENTS CONSIDERED TO BE RELEVANT**

| Category* | Citation of document, with indication, where appropriate, of the relevant passages | Relevant to claim No. |
|---|---|---|
| Y | JP 04-324658 A (CANON KABUSHIKI KAISHA) 13 November 1992 (1992-11-13) paragraph [0009], fig. 1-6 | 12 |
| A | | 1-11 |
| A | JP 2018-206992 A (TOKYO ELECTRON LIMITED) 27 December 2018 (2018-12-27) paragraph [0040], fig. 4 | 1-12 |
| A | JP 2012-064918 A (TOKYO ELECTRON LIMITED) 29 March 2012 (2012-03-29) paragraphs [0062], [0079], [0098]-[0107], fig. 10, 13-14 | 1-12 |
| A | JP 2018-164033 A (TOKYO SEIMITSU CO., LTD.) 18 October 2018 (2018-10-18) paragraph [0039], fig. 7-8 | 1-12 |

Form PCT/ISA/210 (second sheet) (July 2022)

## INTERNATIONAL SEARCH REPORT
### Information on patent family members

International application No.

**PCT/JP2023/044560**

| Patent document cited in search report | | | Publication date (day/month/year) | Patent family member(s) | | | Publication date (day/month/year) |
|---|---|---|---|---|---|---|---|
| JP | 2015-156437 | A | 27 August 2015 | US | 2015/0235888 | A1 | |
| | | | | paragraphs [0036]-[0038], [0042], [0045]-[0047], [0056], [0062]-[0071], fig. 1-6, 9-11 | | | |
| | | | | KR | 10-2015-0098570 | A | |
| | | | | TW | 201543189 | A | |
| JP | 2020-104240 | A | 09 July 2020 | (Family: none) | | | |
| JP | 2022-123417 | A | 24 August 2022 | (Family: none) | | | |
| JP | 04-324658 | A | 13 November 1992 | EP | 456426 | A1 | |
| | | | | p. 2, lines 15-24, fig. 1-6 | | | |
| | | | | US | 5374829 | A | |
| JP | 2018-206992 | A | 27 December 2018 | US | 2018/0350644 | A1 | |
| | | | | paragraph [0052], fig. 4 | | | |
| | | | | CN | 109003931 | A | |
| | | | | KR | 10-2018-0133334 | A | |
| JP | 2012-064918 | A | 29 March 2012 | EP | 2421034 | A2 | |
| | | | | paragraphs [0063], [0080], [0097]-[0106], fig. 10, 13-14 | | | |
| | | | | US | 2012/0046904 | A1 | |
| | | | | KR | 10-2012-0023517 | A | |
| | | | | CN | 102376612 | A | |
| | | | | SG | 178699 | A | |
| | | | | TW | 201230240 | A | |
| JP | 2018-164033 | A | 18 October 2018 | (Family: none) | | | |

Form PCT/ISA/210 (patent family annex) (July 2022)

**REFERENCES CITED IN THE DESCRIPTION**

**Patent documents cited in the description**

- JP 2006192522 A

- JP 2017112291 A